# EUROPÄISCHE PATENTSCHRIFT

(11) **EP 2 097 920 B1**
(45) Veröffentlichungstag und Bekanntmachung des Hinweises auf die Patenterteilung: **09.08.2017**
(21) Anmeldenummer: 07817617.9
(22) Anmeldetag: 04.10.2007
(51) Int. Cl.: H01J 37/32, H03H 11/30

(54) **PLASMAVERSORGUNGSEINRICHTUNG**
PLASMA SUPPLY DEVICE
DISPOSITIF D'ALIMENTATION EN PLASMA

(30) Priorität: 23.07.2007 US 951392 P
(43) Veröffentlichungstag der Anmeldung: 09.09.2009
(73) Patentinhaber: TRUMPF Hüttinger GmbH + Co. KG, 79111 Freiburg im Breisgau (DE)
(72) Erfinder: KIRCHMEIER, Thomas, 79331 Teningen (DE); WINDISCH, Hans-Jürgen, 79238 Ehrenkirchen (DE); KNAUS, Hanns-Joachim, 79312 Emmendingen (DE); GLÜCK, Michael, 79111 Freiburg (DE); HINTZ, Gerd, 79292 Pfaffenweiler (DE)
(74) Vertreter: Kohler Schmid Möbus Patentanwälte
(86) Internationale Anmeldenummer: PCT/DE2007/001775
(87) Internationale Veröffentlichungsnummer: WO 2009/012735

(56) Entgegenhaltungen:
- US-A- 5 424 691
- US-A1- 2003 215 373

## Beschreibung

Die Erfindung betrifft eine Plasmaversorgungseinrichtung zur Erzeugung einer Ausgangsleistung > 500 W bei einer im Wesentlichen konstanten Grundfrequenz > 3 MHz und zur Leistungsversorgung eines Plasmaprozesses, an welchen die erzeugte Ausgangsleistung geliefert wird und von welchem reflektierte Leistung zumindest bei Fehlanpassung an die Plasmaversorgungseinrichtung zurückgeleitet wird, mit zumindest einem an eine DC-Stromversorgung angeschlossenen Inverter, der zumindest ein schaltendes Element aufweist, und mindestens einem Ausgangsnetzwerk.

Eine derartige Plasmaversorgungseinrichtung wird zur Plasmastromversorgung, d.h., zur Stromversorgung von Plasmaprozessen eingesetzt. Die Plasmaversorgungseinrichtung arbeitet bei einer Grundfrequenz, die bei dessen Einsatz als Plasmastromversorgung nur geringfügig von einem Sollwert abweichen darf. Typische Grundfrequenzen sind 3,39 MHz, 13,56 MHz, 27 MHz, 40 MHz, 62 MHz. Der Inverter, der das zumindest eine schaltende Element aufweist, generiert aus dem DC-Signal der DC-Stromversorgung ein Wechselsignal, welches periodisch mit der Grundfrequenz sein Vorzeichen ändert. Dazu wird das zumindest eine schaltende Element im Takt der Grundfrequenz zwischen einem leitenden und einem nichtleitenden Zustand hin- und hergeschaltet. Das Ausgangsnetzwerk generiert aus dem durch den Inverter generierten Wechselsignal ein sinusförmiges Ausgangssignal im Wesentlichen bei der vorgegebenen Grundfrequenz.

Bei einem Plasma handelt es sich um einen besonderen Aggregatszustand, der aus einem Gas erzeugt wird. Jedes Gas besteht grundsätzlich aus Atomen und/oder Molekülen. Bei einem Plasma ist dieses Gas zu einem Großteil ionisiert. Dies bedeutet, dass durch die Zufuhr von Energie die Atome bzw. Moleküle in positive und negative Ladungsträger, also in Ionen und Elektronen, aufgespalten werden. Ein Plasma eignet sich zur Bearbeitung von Werkstücken, da die elektrisch geladenen Teilchen chemisch hochgradig reaktiv sind und zudem durch elektrische Felder beeinflussbar sind. Die geladenen Teilchen können mittels eines elektrischen Feldes auf ein Werkstück beschleunigt werden, wo sie beim Aufprall einzelne Atome aus dem Werkstück herauslösen können. Die herausgelösten Atome können über Gasfluss abtransportiert werden (Ätzen) oder auf andere Werkstücke beschichtet werden (Herstellung von Dünnfilmen). Anwendung findet eine solche Bearbeitung mittels eines Plasmas vor allem dann, wenn extrem dünne Schichten, insbesondere im Bereich weniger Atomlagen, bearbeitet werden sollen. Typische Anwendungen sind Halbleitertechnik (Beschichten, Ätzen, etc.), Flachbildschirme (ähnlich Halbleitertechnik), Solarzellen (ähnlich Halbleitertechnik), Architekturglasbeschichtung (Wärmeschutz, Blendschutz, etc.), Speichermedien (CD, DVD, Festplatten), dekorative Schichten (farbige Gläser, etc.) und Werkzeughärtung. Diese Anwendungen haben hohe Anforderungen an Genauigkeit und Prozessstabilität.

Um aus einem Gas ein Plasma zu generieren, muss ihm Energie zugeführt werden. Das kann auf unterschiedliche Weise, beispielsweise über Licht, Wärme, elektrische Energie, erfolgen. Bei Erzeugung mittels elektrischer Energie spricht man vom Zünden des Plasmas. Ein Plasma zur Bearbeitung von Werkstücken wird typischerweise in einer Plasmakammer gezündet. Dazu wird in der Regel ein Edelgas, z.B. Argon, mit niedrigem Druck in die Plasmakammer geleitet. Über Elektroden und/oder Antennen wird das Gas einem elektrischen Feld ausgesetzt. Ein Plasma entsteht bzw. wird gezündet, wenn mehrere Bedingungen erfüllt sind. Zunächst muss eine geringe Anzahl von freien Ladungsträgern vorhanden sein, wobei zumeist die stets in sehr geringem Maß vorhandenen freien Elektronen genutzt werden. Die freien Ladungsträger werden durch das elektrische Feld so stark beschleunigt, dass sie beim Aufprall auf Atome oder Moleküle des Edelgases weitere Elektronen herauslösen, wodurch positiv geladene Ionen und weitere negativ geladene Elektronen entstehen. Die weiteren freien Ladungsträger werden wiederum beschleunigt und erzeugen beim Aufprall weitere Ionen und Elektronen. Es setzt ein Lawineneffekt ein. Der ständigen Erzeugung von Ionen und Elektronen wirkt die natürliche Rekombination entgegen, d.h., Elektronen werden von Ionen angezogen und rekombinieren zu elektrisch neutralen Atomen bzw. Molekülen. Deshalb muss einem gezündeten Plasma beständig Energie zugeführt werden, um dieses aufrecht zu erhalten.

Plasmastromversorgungen werden zur Erzeugung bzw. Zündung und zur Aufrechterhaltung eines Plasmas eingesetzt, können jedoch auch zur Anregung von Gaslasern eingesetzt werden. Plasmastromversorgungen müssen möglichst kleine Abmessungen besitzen, damit sie in der Anwendung nah an den Plasmaentladungen angeordnet werden können. Sie sollen möglichst wiederholgenau und exakt arbeiten und möglichst geringe Verluste aufweisen, um einen hohen Wirkungsgrad zu realisieren. Eine weitere Anforderung sind möglichst geringe Herstellungskosten und hohe Wartungsfreundlichkeit. Nach Möglichkeit sollen Plasmastromversorgungen ohne mechanisch angetriebene Bauteile auskommen, insbesondere sind Lüfter aufgrund ihrer begrenzten Lebensdauer und der Gefahr von Verschmutzungen unerwünscht. Weiter sollen Plasmastromversorgungen gleichzeitig möglichst zuverlässig sein, sich nicht überhitzen und eine lange Betriebsdauer aufweisen.

Aufgrund der hohen Dynamik und den oftmals chaotischen Verhältnissen in Plasmaprozessen ist eine Plasmastromversorgung viel höheren Anforderungen ausgesetzt als irgendeine andere Stromversorgung. Ein ungezündetes Gas, das nur eine sehr geringe Anzahl von freien Ladungsträgern besitzt, weist eine nahezu unendlich hohe Impedanz auf. Ein Plasma besitzt aufgrund seiner großen Anzahl freier Ladungsträger eine relativ niedrige Impedanz. Beim Zünden des Plasmas erfolgt also ein sehr schneller Impedanzwechsel. Ein gezündetes Plasma hat als weitere Eigenschaft, dass sich die Impedanz sehr schnell und oftmals unvorhersehbar ändern kann, man sagt die Impedanz ist dynamisch. Die Impedanz des Plasmas ist zudem auch noch im hohen Grad nichtlinear. Das bedeutet, dass eine Änderung der Spannung am Plasma nicht die analoge Änderung des Stroms hervorruft. Beispielsweise kann der Strom bei steigender Spannung sehr viel schneller ansteigen, hervorgerufen beispielsweise durch einen Lawineneffekt, oder der Strom kann auch bei so genannter negativer Impedanz mit steigender Spannung absinken.

Wenn eine Stromversorgung eine Leistung in Richtung Last, wie einer Plasmalast, abgibt, die mit endlicher Geschwindigkeit zur Last fließt, dort aber nicht aufgenommen werden kann, weil sich bei der vorhandenen Spannung an der Last auf Grund der unterschiedlichen Impedanz nicht derselbe Strom einstellt, so wird nur der Teil der Leistung absorbiert, der sich aus Spannung und Strom in die Last berechnet, der restliche Anteil der Leistung wird reflektiert. Dies erfolgt zwar auch bei Stromversorgungen mit niedrigen Frequenzen und auch bei Gleichstrom, nur bei diesen erfolgt das so schnell, dass sich die Spannung am Ausgang der Stromversorgung praktisch noch nicht verändert hat, wenn die reflektierte Energie zurück kommt. Es passiert für den Beobachter also zeitgleich. Bei Hochfrequenztechnik mit Frequenzen oberhalb ca. 1 MHz haben sich die Spannung und der Strom am Ausgang der Stromversorgung aber in der Regel schon verändert, wenn die reflektierte Leistung zurückkommt.

Die reflektierte Leistung hat einen beachtlichen Einfluss auf die Stromversorgungen in der Hochfrequenztechnik. Sie kann Stromversorgungen destabilisieren und deren bestimmungsgemäßen Betrieb verhindern. Die reflektierte Leistung auf Grund von Fehlanpassungen hat bei konstanten Impedanzen nur Anteile bei der Grundfrequenz. Diese lassen sich mit Filtern nicht blockieren und nicht absorbieren, weil Filter nicht zwischen vorwärts (zur Last) laufender Welle und rückwärts (von der Last) laufender Welle unterscheiden können und demzufolge auch die vorwärts laufende Welle blockieren oder absorbieren würden. Um die reflektierte Leistung zu minimieren, werden so genannte Impedanzanpassungsglieder bzw. -netzwerke eingesetzt, die sich in der Hochfrequenztechnik einfach durch Kombinationen von Induktivitäten, Kapazitäten und Widerständen realisieren lassen, wobei Widerstände nicht zwingend erforderlich sind. Wenn die Last aber keine konstante Impedanz ist, sondern eine dynamische und nichtlineare, so kommt es zu mindestens zwei zusätzlichen problematischen Phänomenen. Erstens werden von der nichtlinearen, dynamischen Impedanz Energien bei Frequenzen erzeugt, die ungleich der Grundfrequenz sind, und Teile dieser Frequenzen werden in Richtung der Stromversorgung geleitet. Diese werden mit Filtern blockiert bzw. absorbiert. Zweitens können die Impedanzanpassungsglieder den schnellen dynamischen Impedanzänderungen nicht schnell genug folgen, wodurch vermehrt Reflexionen bei der Grundfrequenz entstehen, die von der dynamischen Impedanz zu der Stromversorgung geleitet werden.

Anders als bei allen anderen Stromversorgungen müssen Plasmastromversorgungen mit jedem beliebigen Fehlabschluss belastbar sein, von Leerlauf über Kurzschluss, von unendlich hoher kapazitiver Belastung bis zu unendlich hoher induktiver Belastung. In jedem Punkt des Smith-Diagramms muss eine Plasmastromversorgung zumindest kurzfristig Leistung liefern können und darf dabei keinen dauerhaften Schaden nehmen. Das hängt mit der hohen Dynamik und mit den oftmals chaotischen Verhältnissen in einem Plasmaprözess zusammen. Zusätzlich können auch noch Frequenzen ungleich der Grundfrequenz auftreten, die in einem weiten Bereich auftreten und zu keinem dauerhaften Schaden der Plasmastromversorgung führen dürfen. Das Erkennen und schnelle Abschalten eines fehlerhaften Abschlusses ist dabei erlaubt, aber die Plasmastromversorgung sollte möglichst keinen Schaden nehmen.

Aus der US 2003/0215373 A1 ist eine Steuer- und Verstärkereinheit mit einer Steuerplatine zur Erzeugung eines schwachen Wechselstromsignals bekannt. Das von der Steuerplatine erzeugte Wechselstromsignal wird bei Durchlaufen einer Verstärkeranordnung schrittweise bis aus 3000 W verstärkt. Hierzu dienen Klasse AB Push-Pull Verstärker, die jeweils zwei MOSFETs aufweisen. Die Verstärker zeichnen sich durch ein lineares Verhalten aus und arbeiten mit asymmetrischer Spannungsversorgung.

Aufgabe der vorliegenden Erfindung ist es, eine Plasmaversorgungseinrichtung bereitzustellen, die den genannten Anforderungen für eine Plasmastromversorgung genügt.

Diese Aufgabe wird durch eine Plasmaversorgungseinrichtung mit den Merkmalen des Anspruchs 1 gelöst. Durch diese Maßnahme kann das Ausgangsnetzwerk besonders kostengünstig realisiert werden. Außerdem ist es möglich, die Bauelemente des Ausgangsnetzwerks mit exakten Induktivitäten und Kapazitäten, d. h. Induktivitäts- und Kapazitätswerten, die von Stillwerten allenfalls geringfügig abweichen, zu realisieren. Dies ist bei einer hohen Wiederholgenauigkeit möglich. Auf der Leiterplatte kann weiter mindestens ein Eingangsanschluss zum Anschluss des zumindest einen Inverters und/oder der zumindest eine Inverter angeordnet sein. Das Ausgangsnetzwerk besitzt einen großen Einfluss auf die Zuverlässigkeit und folglich auf die Lebensdauer der gesamten Plasmastromversorgung bzw. der Plasmaversorgungseinrichtung. Zumindest ein Bauteil der Plasmaversorgungseinrichtung kann derart ausgebildet sein, dass es von dem Plasmaprozess reflektierte Leistung bei der Grundfrequenz zumindest teilweise absorbiert. Dabei kann die reflektierte Leistung in Wärme umgewandelt werden. Die reflektierte Leistung kann zumindest teilweise absorbiert werden von dem Inverter, von verlustbehafteten Induktivitäten, Übertragern, Kapazitäten oder Widerständen.

Bei der Plasmaversorgungseinrichtung ist das Ausgangsnetzwerk derart dimensioniert, dass die Fläche der Leiterplatte kleiner als 150 cm² gehalten werden kann. Die Dicke der Leiterplatte beträgt typischerweise 2 bis 5 mm. Als Leiterplattenmaterial kann glasfaserverstärktes Epoxydharz, insbesondere FR4- oder FR5-Material, verwendet werden. Die Schaltung kommt mit diesen Materialien aus, obwohl sie ein verlustbehafteteres dielektrisches Verhalten und eine geringere Wärmeleitfähigkeit und Wärmebeständigkeit als vergleichsweise sehr teure Keramiken oder PTFE-Materialen aufweisen. Mehrlagige Leiterplatten mit flächig ausgebildeten Induktivitäten und SMD-Bauteilen sind für niedrigere Frequenz- und Leistungsbereiche bekannt. Entgegen des Vorurteils, die für die bekannten Leiterplatten verwendeten Materialien seien für Hochfrequenzanwendungen mit einer Ausgangsleistung > 500 W und einer Grundfrequenz > 3 MHz aufgrund hoher Wärmeentwicklung und schlechter Wärmeabführung ungeeignet, wird vorgeschlagen, ein Ausgangsnetzwerk mit planaren Induktivitäten und Kapazitäten auf einer Leiterplatte für den genannten Ausgangsleistungs- und Hochfrequenzbereich zu realisieren. Dies führt zu erheblichen Einsparungen beim Platzbedarf und Kostenaufwand sowie zu einer verbesserten Genauigkeit und Reproduzierbarkeit bei der Herstellung der Plasmaversorgungseinrichtung.

In vorliegender Beschreibung werden die Begriffe Induktivität oder Kapazität bzw. Kondensator einerseits für ein auf der Leiterplatte angeordnetes Bauteil, andererseits für eine dem Bauteil zugeordnete physikalische Größe verwendet, wobei sich die entsprechende Verwendung jeweils aus dem Zusammenhang ergibt.

In einer Ausführungsform der Plasmaversorgungseinrichtung weist das mindestens eine Ausgangsnetzwerk mindestens einen Ausgangsübertrager mit einer primärseitigen Wicklung und einer sekundärseitigen Wicklung auf. Durch den Ausgangsübertrager wird eine galvanische Trennung zwischen dem zumindest einen an eine DC-Stromversorgung angeschlossenen Inverter und einer an die Leiterplatte anzuschließenden Last, insbesondere einer Plasmalast, erreicht. Auf diese Weise werden niederfrequente Signale, insbesondere DC-Anteile, welche am Ausgang des Inverters vorhanden sein können, abgetrennt. Zur galvanischen Trennung kann alternativ eine Kapazität eingesetzt werden. Durch die Ausbildung ausreichender Sicherheitsabstände kann die Primärseite des Ausgangsübertragers galvanisch mit dem Netzanschluss verbunden bleiben. Durch den damit einhergehenden Verzicht auf eine galvanische Trennung in der DC-Stromversorgung können die Kosten und die Baugröße der Plasmaversorgungseinrichtung weiter verringert werden.

Der Ausgangsübertrager kann in Planartechnologie realisiert sein. Ein derart hergestellter, auf der Leiterplatte angeordneter Ausgangsübertrager kann sehr präzise gefertigt werden, insbesondere können die Windungen der primär- und der sekundärseitigen Wicklung bei einer guten Reproduzierbarkeit hergestellt werden. Darüber hinaus ist dies kostengünstiger als ein Aufbau mit Drahtwicklungen. Weiter kann der Ausgangsübertrager großflächig aufgebaut und somit in einfacher Weise gekühlt werden.

In einer weiteren Ausführungsform ist die Leiterplatte mehrlagig, insbesondere mit vier Lagen, ausgebildet, und in jeder Lage der Leiterplatte ist eine Windung des Ausgangsübertragers ausgebildet. Hieraus ergibt sich der Vorteil, dass die kapazitive Kopplung zwischen den Windungen, die üblicherweise als unerwünschte, parasitäre Kapazität betrachtet wird, für weitere Schaltungsteile, beispielsweise für ein Impedanzanpassungsglied, verwendet werden kann. Zudem können die Streuinduktivitäten des Ausgangsübertragers für weitere Schaltungsteile mitverwendet werden.

In einer Ausführungsform weisen die primärseitige Wicklung und die sekundärseitige Wicklung des Ausgangsübertragers jeweils zwei Windungen auf. Auf diese Weise können alle vier Lagen der Leiterplatte genutzt werden. Die gleichzeitig entstehende magnetische Kopplung und die Streuinduktivität können beispielsweise einen LC-Filter bilden.

In einer Ausführungsform der Plasmaversorgungseinrichtung weist das Ausgangsnetzwerk mindestens einen zwischen dem Eingangsanschluss und der primärseitigen Wicklung angeordneten Satz erster Induktivitäten auf. Unter einem "Satz erster Induktivitäten" ist zu verstehen, dass jeder Inverter über eine erste Induktivität mit dem ihm zugeordneten Ausgangsübertrager verbunden ist. Die ersten Induktivitäten können als planare Leiterbahnen ausgebildet sein, die jeweils eine Windung aufweisen. Zweckmäßigerweise sind die ersten Induktivitäten magnetisch gekoppelt, wodurch auf Magnetfeldverstärkungselemente verzichtet werden kann. Zusätzliche Magnetfeldverstärkungselemente können die Induktivität aber noch erhöhen. Es werden Induktivitäten im Bereich von 50 bis 300 nH erreicht. Die Induktivitäten können Werte größer 50 nH und Güten größer 200 aufweisen. In einer Ausführungsform können Leiterbahnen zum Beispiel für die ersten Induktivitäten in mehreren Lagen parallel geführt werden. Der Strom verteilt sich auf die Leiterbahnen und die Verluste werden geringer. Damit steigt die Güte der Induktivitäten auf Werte größer 200. Das war bisher mit planaren Induktivitäten im Bereich von 50 bis 300 nH auf nur einer Lage unerreicht.

Die Inverterschaltung der Plasmaversorgungseinrichtung kann zwei Halbbrücken aufweisen, die jeweils an die DC-Stromversorgung angeschlossen sind. Indem die Mittelpunkte der Halbbrückenschaltung über die ersten Induktivitäten mit der primärseitigen Wicklung des Ausgangsübertragers verbunden werden, kann ein verlustarmes Null-Volt-Einschalten über einen weiten Bereich von Lastimpedanzen erreicht werden. Mittels der Plasmaversorgungseinrichtung können vorteilhafte Schaltbedingungen für den Inverter sichergestellt werden. Vorteilhaft sind beispielsweise ein Null-Volt-Einschalten vor allem bei höheren Frequenzen und bei MOSFETs oder ein Null-Strom-Ausschalten vor allem bei niedrigen Frequenzen und bei IGBTs als Schalter im Inverter. Dies kann durch eine geeignete Dimensionierung des Ausgangsnetzwerks bzw. der Schaltungsteile des Ausgangsnetzwerks erreicht werden.

Der Abstand zwischen mindestens zwei Lagen der Leiterplatte kann wesentlich größer sein als der für die Spannungsfestigkeit erforderliche Abstand.

In einer Ausführungsform der Plasmaversorgungseinrichtung bildet die durch die Leiterbahnen gebildete Kapazität zwischen den Windungen der sekundärseitigen Wicklung des mindestens einen Ausgangsübertragers zusammen mit der Induktivität der sekundärseitigen Wicklung des mindestens einen Ausgangsübertragers einen LC-Filter. Die durch die Leiterbahnen zwischen der primärseitigen Wicklung und der sekundärseitigen Wicklung des mindestens einen Ausgangsübertragers gebildete Kapazität kann ein weiterer Bestandteil des LC-Filters sein.

In einer Ausführungsform kann das Ausgangsnetzwerk ein zwischen der sekundärseitigen Wicklung und einem Ausgangsanschluss zum Anschluss einer Last angeordnetes Impedanzanpassungsglied mit einer oder mehreren zweiten Induktivitäten und/oder einem oder mehreren Kondensatoren aufweisen. Auf diese Weise wird eine Lastimpedanzanpassung vom Inverter zum Ausgang des Ausgangsnetzwerks erreicht. Durch reaktive Bauelemente des Ausgangsnetzwerks, d. h. Induktivitäten und Kapazitäten, werden die von einer Plasmalast reflektierten und/oder erzeugten Leistungsanteile gefiltert.

Weiter kann das Ausgangsnetzwerk einen LC-Filter aufweisen. Am Ausgang des Inverters liegt in der Regel ein Signal mit einem relativ hohen Anteil von Oberwellen bzw. harmonischen Frequenzen an, welche am Ausgang der Plasmastromversorgung, d. h., am Ausgangsanschluss unerwünscht sind. Die Plasmaversorgungseinrichtung filtert diese Oberwellen bzw. harmonischen Frequenzen mit Hilfe des LC-Filters. Zweckmäßigerweise bilden die Streuinduktivität und die Kapazität zwischen zwei Windungen des Ausgangsübertragers einen LC-Filter, wodurch zusätzliche Bauelemente eingespart werden können. Der LC-Filter ist entweder wie oben beschrieben ausgebildet und/oder Teil des Impedanzanpassungsglieds. In einer weiteren Ausführungsform weist das Ausgangsnetzwerk einen zur sekundärseitigen Wicklung parallelen SMD-Kondensator auf. Die Kapazität zwischen den sekundärseitigen Windungen kann dann die Kapazität dieses Kondensators verstärken.

Weiter können die zweite Induktivität bzw. Induktivitäten in Planartechnologie realisiert sein. Der Kondensator bzw. die Kondensatoren können beispielsweise in Planartechnologie und/oder als SMD-Bauteil realisiert sein. Hieraus ergibt sich der Vorteil einer verbesserten Genauigkeit und Reproduzierbarkeit bei der Herstellung der Plasmaversorgungseinrichtung.

Die Leiterplatten können Durchkontaktierungen zum Verbinden der in den Lagen angeordneten Leiterbahnen aufweisen. Auf diese Weise werden eine hohe Festigkeit der Leiterplatte und gute Kontakte zwischen den auf dieser angeordneten Schaltungsteilen sichergestellt. Sowohl der Eingangsanschluss zum Anschluss der DC-Stromversorgung oder des Inverters als auch der Ausgangsanschluss zum Anschluss der Plasmalast, an welche das durch das Ausgangnetzwerk generierte sinusförmige Ausgangssignal übergeben wird, können mit Durchkontaktierungen verbunden werden. An Leiterkarten aus dem Stand der Technik, die aus Wärmeleitgründen direkt auf der Kühlplatte montiert wurden, konnten keine solche Durchkontaktierungen vorgesehen werden, da sie einen Kurzschluss zwischen der auf Massepotential liegenden Kühlplatte und den Potentialen der Durchkontaktierungen verursacht hätten.

In einer Ausführungsform der Plasmaversorgungseinrichtung ist an der Leiterplatte zumindest ein einer oder mehreren Induktivitäten und/oder Wicklungen des Ausgangsübertragers zugeordnetes Magnetfeldverstärkungselement vorgesehen. Auf diese Weise kann die Anzahl der Windungen für die einzelnen Induktivitäten reduziert werden. Dadurch ist es möglich, mit kurzen Leiterbahnen hohe Induktivitäten zu erzielen. Durch die kurzen Leiterbahnen ergibt sich zudem der Vorteil geringer Widerstände und damit einhergehender geringerer Verluste.

Ein Magnetfeld B wird verursacht durch eine magnetische Feldstärke H. Diese wird wiederum verursacht durch einen Strom I durch eine Leitung, welche eine Induktivität bildet. Zwischen B und H besteht die Beziehung B = µ * H wobei µ die Permeabilität ist. Die Permeabilität µ setzt sich zusammen aus der Permeabilität des Vakuums µₒ = 4π*10⁻⁷ Vs/Am und der Permeabilitätszahl µᵣ, die materialabhängig ist. Es gilt µ = µ₀*µᵣ Ein Magnetfeldverstärkungselement weist ein µᵣ deutlich größer als 1 auf. Typischerweise wird bei den genannten Frequenzen ein Ferrit als Magnetfeldverstärkungselement verwendet. Das Magnetfeldverstärkungselement erhöht bei Induktivitäten den Wert der Induktivität entsprechend der Permeabilitätszahl µᵣ.

In einer Ausführungsform kann das zumindest eine Magnetfeldverstärkungselement ein Ferrit, insbesondere ein Perminvarferrit, sein. Typischerweise umschließen die Magnetfeldverstärkungselemente oder Ferrite ringförmig die Leiterbahnen der planaren Induktivitäten. Die Ferrite, die die Windungen der Induktivitäten bzw. der Wicklungen ring- bzw. schalenförmig umschließen, bestehen zweckmäßigerweise aus zwei Teilen, welche gegenstückartig an der Leiterplatte angeordnet werden.

Weiter kann an der Leiterplatte zumindest eine Aussparung zur Aufnahme des zumindest einen Magnetfeldverstärkungselements ausgebildet sein. Typischerweise sind an der Leiterplatte Aussparungen zur Aufnahme des zweiteilig aus zwei gleichen oder zumindest ähnlichen Teilen bestehenden Magnetfeldverstärkungselements ausgebildet. Auf diese Weise kann das Magnetfeldverstärkungselement sicher und platzsparend an der Leiterplatte angeordnet werden.

In einer Ausführungsform weist die Plasmaversorgungseinrichtung eine mit der Leiterplatte verbundene Kühlplatte auf. In einer Ausführungsform ist die Kühlplatte kühlmitteldurchströmt, wodurch eine Plasmastromversorgung ohne forcierte Luftströmung, d. h. ohne Lüfter realisiert werden kann. In einer Ausführungsform ist die Kühlplatte mit Massepotential verbunden, was für eine gute elektrische Abschirmung des Ausgangsnetzwerks sorgt.

Für eine ausreichende Spannungsfestigkeit in Abhängigkeit von der maximalen Spannung, die zwischen den Leiterbahnen zweier Lagen der Leiterplatte entstehen kann, ist üblicherweise ein Abstand von 1 µm/V notwendig. Um eine allzu große Wärmeentwicklung beim Betrieb der Plasmaversorgungseinrichtung zu vermeiden, wird ein höherer Mindestabstand der Leiterbahnen zwischen zwei Lagen vorgeschlagen, da mit diesem erweiterten Mindestabstand die dielektrischen Verluste geringer werden. Dieser höhere Mindestabstand beträgt typischerweise 10 µm/V. In einer Ausführungsform kann die Leiterplatte von der Kühlplatte beabstandet, insbesondere mit einem Abstand von 5 mm bis 20 mm, angeordnet sein. Die Induktivitäten können so mit einer größeren Güte und mit geringen Verlusten realisiert werden.

In einer Ausführungsform kann das Ausgangsnetzwerk von der Kühlplatte mit einem Abstand angeordnet sein, der in Beziehung zur Dicke eines die Induktivität(en) und/oder die Wicklungen des Ausgangsübertragers umschließenden Magnetfeldverstärkungselements steht. Die Magnetfeldverstärkungselemente können rechteck-ringförmig die Induktivitäten umschließen und plan auf der Kühlplatte aufgelegt werden, eventuell zur mechanischen Entlastung mit elastischen Wärmeübertragungselementen zwischen der Kühlplatte und den Magnetfeldverstärkungselementen. Das sorgt für eine gute Wärmeableitung der in den Magnetfeldverstärkungselementen entwickelten Wärme. Die Realisierung eines Ausgangsnetzwerkes mit dem extrem kostengünstigen mehrlagigen FR4- oder FR5-Material und mit Durchkontaktierungen ist erst möglich geworden, als man sich von der vorherrschenden Meinung abwandte, dass sich die gesamte mit planaren Induktivitäten versehene Leiterplatte flächig in Kontakt mit der Kühlplatte befinden muss.

In einer Ausführungsform sind zwischen der Leiterplatte und der Kühlplatte ein oder mehrere elektrisch isolierende Wärmeübertragungselemente angeordnet. Mittels der Wärmeübertragungselemente, die zweckmäßigerweise zudem elastisch ausgebildet sind, wird die Wärme von der Leiterplatte auf die Kühlplatte abgeführt. Von den Stellen auf der Leiterplatte, an denen eine starke Wärmeentwicklung stattfindet, beispielsweise im Bereich des Ausgangsübertragers, wird die Wärme mit Hilfe von flächigen Kupferleiterbahnen zu Stellen mit geringerer Wärmeentwicklung abgeführt. Die Wärmeübertragungselemente können in der Nähe des Ausgangsübertragers angeordnet sein und es können Leiterbahnen durch das dem Ausgangsübertrager zugeordnete Magnetfeldverstärkungselement hindurch zu den Wärmeübertragungselementen geführt sein. Im Bereich eines umschließenden Magnetfeldverstärkungselements wie eines Ferrits, d. h. im Bereich großer Ströme, können nur in umständlicher Weise elektrisch isolierende, flächig ausgebildete Wärmeübertragungselemente angeordnet werden. Mit Hilfe der Kupferleiterbahnen wird die Wärme bzw. Hitze möglichst weit aus dem Bereich des Magnetfeldverstärkungselements herausgeführt und von dort weiter an die Kühlplatte abgeführt.

An der Leiterplatte kann ein Masseanschluss vorgesehen sein. Der Masseanschluss kann als kontaktierte Bohrung ausgebildet sein. Zwischen der Leiterplatte und der Kühlplatte können Abstandsbolzen vorgesehen sein, an denen eine Masseverbindung hergestellt werden kann.

Die obere Leistungsgrenze der Plasmaversorgungseinrichtung ist unter anderem durch die abzuführende Verlustleistung bestimmt. Die obere Leistungsgrenze kann angehoben werden, indem die Plasmaversorgungseinrichtung mindestens zwei Ausgangsnetzwerke auf einer Leiterplatte aufweist, die zusammen von mindestens einem an die DC-Stromversorgung angeschlossenen Inverter oder für sich von jeweils mindestens einem an die DC-Stromversorgung angeschlossenen Inverter gespeist werden und deren Ausgangsleistungen über mindestens einen Koppler zu einer Gesamtleistung zusammengeführt werden können. Ein Koppler ist ein elektronisches Bauteil, das dafür ausgelegt ist, elektrische Leistungen zusammenzuführen oder aufzuteilen. Auch der Koppler kann Bauteile aufweisen, die die reflektierte Leistung zumindest teilweise absorbieren.

Die obere Leistungsgrenze kann ferner angehoben werden, indem das mindestens eine Ausgangsnetzwerk der Plasmaversorgungseinrichtung mindestens zwei Sätze von ersten Induktivitäten und/oder mindestens zwei Ausgangsübertrager und/oder mindestens zwei Impedanzanpassungsglieder aufweist, deren Eingangs- und Ausgangsleistungen jeweils durch mindestens einen Koppler geteilt bzw. zu einer Gesamtleistung zusammengeführt werden.

Der in diesen Fällen mindestens eine benötigte Koppler kann auf der Leiterplatte angeordnet und bevorzugt zumindest teilweise in Planartechnologie realisiert sein.

Bei einer Plasmaversorgungsanordnung werden die Ausgangsleistungen von mindestens zwei Plasmaversorgungseinrichtungen über mindestens einen Koppler zusammengeführt.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: einen vereinfachten Schaltplan einer erfindungsgemäßen Plasmaversorgungseinrichtung;
- **Fig. 2**: einen Schnitt durch eine Leiterplatte mit einem darauf angeordneten Ausgangsnetzwerk sowie durch eine mit der Leiterplatte verbundene Kühlplatte;
- **Fig. 3a bis 3d**: jeweils eine Lage der Leiterplatte aus Fig. 2;
- **Fig.4**: einen vereinfachten Schaltplan einer weiteren erfindungsgemäßen Plasmaversorgungseinrichtung; und
- **Fig. 5a und 5b**: jeweils einen vereinfachten Schaltplan einer beispielhaften zwei Ausgangsnetzwerke aufweisenden Plasmaversorgungseinrichtung.

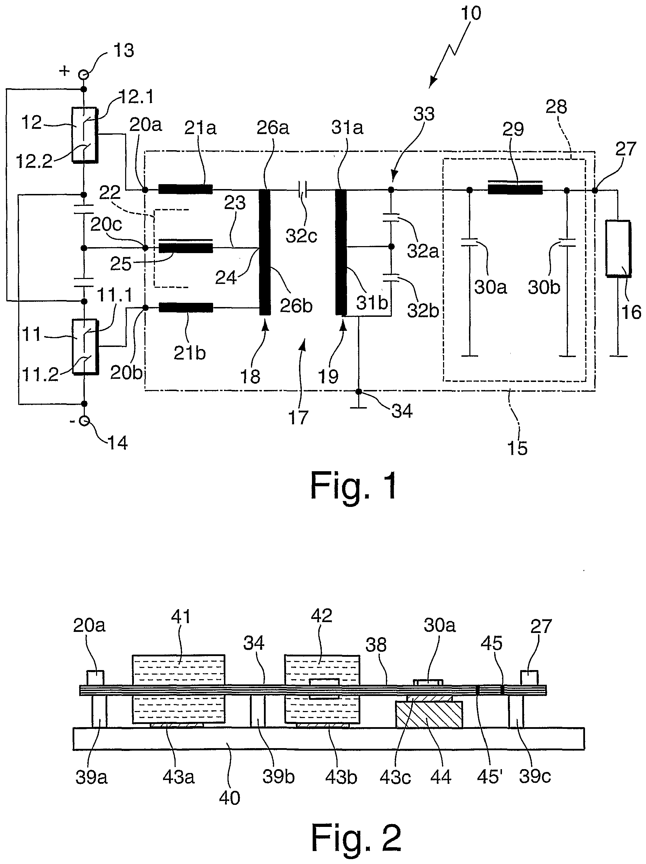

Die **Fig. 1** zeigt eine Plasmaversorgungseinrichtung 10 mit einem ersten Inverter 11 und einem zweiten Inverter 12. Die Inverter 11, 12 sind als Halbbrücken mit jeweils zwei in Serie geschalteten schaltenden Elementen 11.1, 11.2, 12.1, 12.2 ausgebildet. Beide Inverter 11, 12 sind jeweils an einen positiven Versorgungsspannungsanschluss 13 und an einen negativen Versorgungsspannungsanschluss 14 einer DC-Stromversorgung (nicht gezeigt) angeschlossen. Die Plasmaversorgungseinrichtung 10 weist weiter ein Ausgangsnetzwerk 15 auf, an das einerseits die Inverter 11, 12 und andererseits eine Last 16, insbesondere eine Plasmalast, angeschlossen sind. Als zentrales Schaltungsteil weist das Ausgangsnetzwerk 15 einen Ausgangsübertrager 17 mit einer primärseitigen Wicklung 18 und einer sekundärseitigen Wicklung 19 auf.

Zwischen Eingangsanschlüssen 20a, 20b des Ausgangsnetzwerks 15 für die Inverter 11, 12 und der primärseitigen Wicklung 18 des Ausgangsübertragers 17 sind erste Induktivitäten 21a, 21b angeordnet. Die ersten Induktivitäten 21a, 21b sind magnetisch aufgrund ihrer gegenseitigen räumlichen Anordnung auf einer Leiterplatte (in Figur 1 nicht dargestellt) miteinander gekoppelt, was durch die gestrichelte Linie 22 angedeutet ist. Durch das Zusammenschalten der Ausgänge der beiden Inverter 11, 12 kann eine größere Ausgangsleistung mittels der Plasmaversorgungseinrichtung 10 erreicht werden. Über eine weitere Verbindungsleitung 23 ist eine Mittenanzapfung 24 an der primärseitigen Wicklung 18 realisiert, wobei in der weiteren Verbindungsleitung 23 eine weitere Induktivität 25 vorgesehen ist, die an einen Eingangsanschluss 20c, der mit dem Verbindungspunkt der Inverter 11, 12 verbunden ist, angeschlossen ist. Die primärseitige Wicklung 18 weist zwei primärseitige Windungen 26a, 26b auf, welche beidseits der Mittenanzapfung 24 angeordnet sind.

Zwischen der sekundärseitigen Wicklung 19 und einem Ausgangsanschluss 27 für die Last 16 ist ein Impedanzanpassungsglied 28 angeordnet. Das Impedanzanpassungsglied 28 umfasst eine zweite Induktivität 29 und zwei Kondensatoren 30a, 30b. Das Impedanzanpassungsglied 28 kann mehrere zweite Induktivitäten 29 sowie in Serie und/oder parallel geschaltete Kondensatoren 30a, 30b aufweisen. Die sekundärseitige Wicklung 19 weist ebenfalls zwei sekundärseitige Windungen 31a, 31b auf. Mit Hilfe des Ausgangsnetzwerks 15 wird ein an den Eingangsanschlüssen 20a, 20b eingegebenes Wechselsignal in ein am Ausgangsanschluss 27 ausgegebenes sinusförmiges Ausgangssignal generiert. Weiter werden harmonische Frequenzen gefiltert und DC-Anteile abgetrennt.

Der Ausgangsübertrager 17 ist in Planartechnologie realisiert, so dass die primär- und sekundärseitigen Windungen 26a, 26b, 31a, 31b flach übereinander liegen. Zwischen den Windungen 26a, 26b, 31a, 31b des Ausgangsübertragers 17 bestehen Kapazitäten, die durch die weiteren Kondensatoren 32a, 32b, 32c angedeutet sind. Diese sind Bestandteile eines LC-Filters 33, der die sekundärseitige Wicklung 19 und die weiteren Kondensatoren 32a, 32b, 32c umfasst. Weiter ist ein mit der sekundärseitigen Wicklung 19 verbundener Masseanschluss 34 vorgesehen. Die weitere Induktivität 25 und die zweite Induktivität 29 weisen jeweils ein als Perminvarferrit ausgebildetes Magnetfeldverstärkungselement auf. Das Ausgangsnetzwerk 15 ist überwiegend in Planartechnologie realisiert und einschließlich der Eingangsanschlüsse 20a, 20b, 20c, des Masseanschlusses 34 und des Ausgangsanschlusses 27 auf einer mehrlagigen Leiterplatte angeordnet.

In **Fig. 2** ist ein vertikaler Schnitt durch eine horizontal angeordnete, mehrlagige Leiterplatte 38 gezeigt. Die Leiterplatte 38 ist als so genannte Multi-Layer-Platine aufgebaut. Die Leiterplatte 38 ist über Abstandsbolzen 39a, 39b, 39c von einer Kühlplatte 40 beabstandet und mit dieser verbunden. Auf bzw. in der Leiterplatte 38 sind das Ausgangsnetzwerk 15 sowie die Eingangsanschlüsse 20a, 20b für die Inverter 11, 12 und der Ausgangsanschluss 27 für die Last 16 angeordnet. Im Bereich der ersten Induktivitäten 21a, 21b ist ein erstes Magnetfeldverstärkungselement 41, im Bereich des Ausgangsübertragers 17 ein zweites Magnetfeldverstärkungselement 42 angeordnet, wobei die Magnetfeldverstärkungselemente 41, 42 jeweils aus zwei beidseits der Leiterplatte 38 angeordneten Teilen zusammengesetzt sind. Die Kondensatoren 30a, 30b des Impedanzanpassungsglieds 28 sind als SMD-Bauteile ausgebildet.

Im Bereich der Induktivitäten 18, 19, 21a, 21b, 29 des Ausgangsnetzwerks 15 sind elastische, flächig ausgebildete Wärmeübertragungselemente 43a, 43b, 43c zwischen der Leiterplatte 38 und der Kühlplatte 40 angeordnet, wobei im Bereich des Impendanzanpassungsglieds 28 zusätzlich ein als Kupferblock ausgebildetes weiteres Wärmeübertragungselement 44 vorgesehen ist. Mittels der Wärmeübertragungselemente 43a, 43b, 43c, 44 wird die bei Betrieb der Plasmaversorgungseinrichtung 10 im Bereich der Induktivitäten 18, 19, 21a, 21b, 29 entstehende Wärme von der Leiterplatte 38 auf die Kühlplatte 40 abgeführt. Zur verbesserten Wärmeabfuhr können die Magnetfeldverstärkungselemente 41, 42 bereichsweise mit einer Wärmeleitmasse, insbesondere einem Wärmeleitschaum, umgeben sein. Das Ausgangsnetzwerk 15 ist in Planartechnologie mit Leiterbahnen in der mehrlagigen Leiterplatte 38 ausgebildet. Zur Verbindung der Leiterbahnen verschiedener Lagen sind Durchkontaktierungen in der Leiterplatte 38 ausgebildet, beispielhaft sind in Fig. 2 die Durchkontaktierungen 45 und 45' bezeichnet.

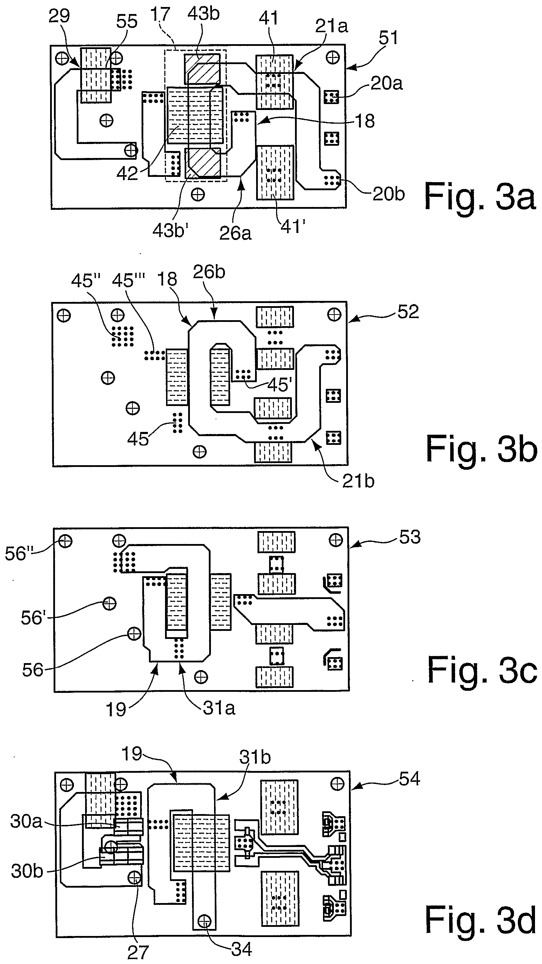

In den **Fig. 3a bis 3d** sind die unterschiedlichen Lagen der Leiterplatte 38, nämlich eine untere Lage 51 (Fig. 3a), eine erste innere Lage 52 (Fig. 3b), eine zweite innere Lage 53 (Fig. 3c) und eine obere Lage 54 (Fig. 3d), dargestellt. Die Magnetfeldverstärkungselemente 41, 41' und 42 sind im Bereich der ersten Induktivitäten 21a, 21b und im Bereich der Induktivitäten 18, 19 des Ausgangsübertragers 17 mit den Windungen 26a, 26b, 31a, 31b angeordnet. Zusätzlich ist ein drittes Magnetfeldverstärkungselement 55 im Bereich des Impedanzanpassungsglieds 28 vorgesehen. Neben Durchkontaktierungen 45, 45', 45", 45"' sind Bohrungen 56, 56', 56" zwischen den Lagen 51, 52, 53, 54 ausgebildet, wodurch gute Kontakte zwischen den Leiterbahnen und eine hohe Festigkeit der Leiterplatte 38 sichergestellt werden. Neben den Eingangsanschlüssen 20a, 20b und dem Ausgangsanschluss 27 ist der Masseanschluss 34 auf der Leiterplatte 38 angeordnet. Auf der oberen Lage 54 sind die als SMD-Bauteile ausgebildeten Kondensatoren 30a, 30b des Impedanzanpassungsglieds 28 angeordnet. Eine mögliche Lage der Wärmeübertragungselemente 43b, 43b' ist in Fig 3a eingezeichnet. Im Ausgangsübertrager 17 fließt ein hoher Strom durch alle vier Lagen 51, 52, 53, 54 der Leiterplatte 38. Hier kommt es deswegen zur höchsten Wärmeentwicklung. Diese Wärme kann innerhalb des als Ferrit ausgebildeten Magnetfeldverstärkungselements 42 nicht ausreichend zur Kühlplatte 40 abgeführt werden. Deswegen wird die Wärme über die in Kupfer ausgebildeten Leiterbahnen aus dem Bereich des Magnetfeldverstärkungselements 42 herausgeführt und über die Wärmeübertragungselemente 43b, 43b' an die Kühlplatte 40 abgeführt.

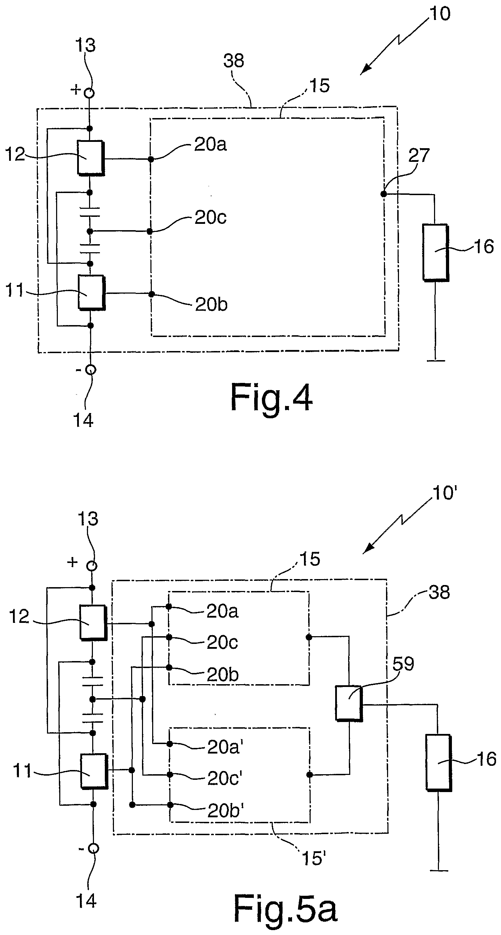

In **Fig. 4** ist die Plasmaversorgungseinrichtung 10 mit den an die Versorgungsspannungsanschlüsse 13, 14 einer DC-Stromversorgung angeschlossenen Invertern 11, 12 und dem Ausgangsnetzwerk 15 gezeigt. Das Ausgangsnetzwerk 15 weist Eingangsanschlüsse 20a, 20b für das von den Invertern 11, 12 erzeugte Eingangssignal und einen Eingangsanschluss 20c für die Mittenanzapfung sowie einen Ausgangsanschluss 27 zum Anschluss einer Last 16 auf. Die Inverter 11, 12 sind ebenso wie das Ausgangsnetzwerk 15, die Eingangsanschlüsse 20a, 20b, 20c und der Ausgangsanschluss 27 auf der Leiterplatte 38 angeordnet.

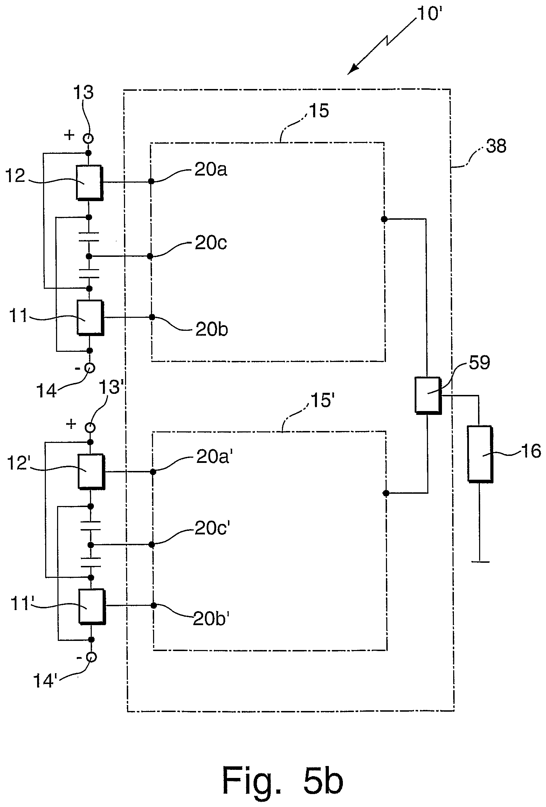

Die **Fig. 5a** **und** **5b** zeigen jeweils eine Plasmaversorgungseinrichtung 10' mit dem Ausgangsnetzwerk 15 und einem weiteren Ausgangsnetzwerk 15'. Beide Ausgangsnetzwerke 15, 15' weisen jeweils drei Eingangsanschlüsse 20a, 20b, 20c bzw. 20a', 20b', 20c' auf. In Fig. 5a sind beide Ausgangsnetzwerke 15, 15' parallel an die Inverter 11, 12 bzw. an die DC-Stromversorgung 13, 14 angeschlossen. Die in der Fig. 5b dargestellte Plasmaversorgungseinrichtung 10' unterscheidet sich davon darin, dass das weitere Ausgangsnetzwerk 15' über weitere Inverter 11', 12' an weitere Versorgungsspannungsanschlüsse 13', 14' einer weiteren unabhängigen DC-Stromversorgung angeschlossen sind. Mittels eines Kopplers 59 werden die Ausgangssignale beider Ausgangsnetzwerke 15, 15' zusammengeführt und an eine Last 16 übergeben. Die Ausgangsnetzwerke 15, 15' einschließlich des Kopplers 59 sind auf der Leiterplatte 38 angeordnet. Es ist zudem denkbar, dass die Inverter 11, 12, 11', 12' auf der Leiterplatte 38 angeordnet sind. Es ist auch denkbar, dass der Koppler 59 außerhalb der Leiterplatte angeordnet ist, zudem ist es auch möglich, dass die Ausgangsnetzwerke mit oder ohne Inverter auf getrennten Leiterplatten realisiert sind.

## Patentansprüche

1. Plasmaversorgungseinrichtung (10, 10') zur Erzeugung einer Ausgangsleistung > 500 W bei einer im Wesentlichen konstanten Grundfrequenz > 3 MHz und zur Leistungsversorgung eines Plasmaprozesses, an welchen die erzeugte Ausgangsleistung geliefert wird und von welchem reflektierte Leistung zumindest bei Fehlanpassung an die Plasmaversorgungseinrichtung (10, 10') zurückgeleitet wird, **dadurch gekennzeichnet, dass** zumindest ein an eine DC-Stromversorgung (13, 14, 13', 14') angeschlossener Inverter (11, 12, 11', 12'), der zumindest ein schaltendes Element (11.1, 11.2, 12.1, 12.2) aufweist, und mindestens ein aus dem durch den Inverter (11, 12, 11', 12') generierten Wechselsignal ein sinusförmiges Ausgangssignal erzeugendes Ausgangsnetzwerk (15, 15') vorgesehen sind, wobei das mindestens eine Ausgangsnetzwerk (15, 15') auf einer Leiterplatte (38) angeordnet ist.

2. Plasmaversorgungseinrichtung nach Anspruch 1, **dadurch gekennzeichnet, dass** das mindestens eine Ausgangsnetzwerk (15, 15') zumindest eine in Planartechnologie realisierte Induktivität (21a, 21b, 29) aufweist.

3. Plasmaversorgungseinrichtung nach einem der vorhergehenden Ansprüche, **dadurch gekennzeichnet, dass** die Leiterplatte (38) aus glasfaserverstärktem Epoxydharz, insbesondere FR4- oder FR5-Material, gefertigt ist.

4. Plasmaversorgungseinrichtung nach einem der vorhergehenden Ansprüche, **dadurch gekennzeichnet, dass** das mindestens eine Ausgangsnetzwerk (15, 15') mindestens einen Ausgangsübertrager (17) mit einer primärseitigen Wicklung (18) und einer sekundärseitigen Wicklung (19) aufweist, wobei der mindestens eine Ausgangsübertrager (17) in Planartechnologie realisiert ist.

5. Plasmaversorgungseinrichtung nach Anspruch 4, **dadurch gekennzeichnet, dass** die durch die Leiterbahnen gebildete Kapazität zwischen den Windungen (31a, 31b) der sekundärseitigen Wicklung (19) des mindestens einen Ausgangsübertragers (17) zusammen mit der Induktivität der sekundärseitigen Wicklung (19) des mindestens einen Ausgangsübertragers (17) einen LC-Filter bildet.

6. Plasmaversorgungseinrichtung nach Anspruch 5, **dadurch gekennzeichnet, dass** die durch die Leiterbahnen zwischen der primärseitigen Wicklung (18) und der sekundärseitigen Wicklung (19) des mindestens einen Ausgangsübertragers (17) gebildete Kapazität ein weiterer Bestandteil des LC-Filters ist.

7. Plasmaversorgungseinrichtung nach einem der Ansprüche 5 oder 6, **dadurch gekennzeichnet, dass** das mindestens eine Ausgangsnetzwerk (15, 15') mindestens ein zwischen der sekundärseitigen Wicklung (19) und mindestens einem Ausgangsanschluss (27) zum Anschluss einer Last (16) angeordnetes Impedanzanpassungsglied (28) mit einer oder mehreren zweiten Induktivitäten (29) und/oder einem oder mehreren Kondensatoren (30a, 30b) aufweist.

8. Plasmaversorgungseinrichtung nach Anspruch 7, **dadurch gekennzeichnet, dass** der bzw. die Kondensator(en) (30a, 30b) in Planartechnologie und/oder als SMD-Bauteil(e) realisiert sind.

9. Plasmaversorgungseinrichtung nach einem der Ansprüche 2 bis 8, **dadurch gekennzeichnet, dass** an der Leiterplatte (38) zumindest ein einer oder mehreren Induktivitäten (21a, 21b, 29) und/oder Wicklungen (18, 19) des mindestens einen Ausgangsübertragers (17) zugeordnetes Magnetfeldverstärkungselement (41, 42, 55) vorgesehen ist.

10. Plasmaversorgungseinrichtung nach Anspruch 9, **dadurch gekennzeichnet, dass** das zumindest eine Magnetfeldverstärkungselement (41, 42, 55) ein Ferrit, insbesondere ein Perminvarferrit, ist.

11. Plasmaversorgungseinrichtung nach Anspruch 9 oder 10, **dadurch gekennzeichnet, dass** an der Leiterplatte (38) zumindest eine Aussparung zur Aufnahme des zumindest einen Magnetfeldverstärkungselements (41, 42, 55) ausgebildet ist.

12. Plasmaversorgungseinrichtung nach einem der vorhergehenden Ansprüche, **dadurch gekennzeichnet, dass** die Plasmaversorgungseinrichtung (10) eine mit der Leiterplatte (38) verbundene Kühlplatte (40) aufweist.

13. Plasmaversorgungseinrichtung nach Anspruch 12, **dadurch gekennzeichnet, dass** die Leiterplatte (38) von der Kühlplatte (40) beabstandet, insbesondere mit einem Abstand von 5 mm bis 20 mm, angeordnet ist, wobei zwischen der Leiterplatte (38) und der Kühlplatte (40) ein oder mehrere bevorzugt elektrisch isolierende Wärmeübertragungselemente (43a, 43b, 43c, 44)und/oder Magnetfeldverstärkungselemente (41, 42, 55) angeordnet sind.

14. Plasmaversorgungseinrichtung nach einem der vorhergehenden Ansprüche, **dadurch gekennzeichnet, dass** mindestens zwei Ausgangsnetzwerke (15, 15') vorhanden sind, deren Ausgangsleistungen durch mindestens einen Koppler (59) zu einer Gesamtleistung zusammengeführt werden.

15. Plasmaversorgungseinrichtung nach Anspruch 14, **dadurch gekennzeichnet, dass** der mindestens eine Koppler (59) auf der Leiterplatte (58) angeordnet und bevorzugt zumindest teilweise in Planartechnologie realisiert ist.

## Claims

1. A plasma supply device (10, 10') for generating an output power > 500 W at an essentially constant basic frequency > 3 MHz and for powering a plasma process, to which the generated output power is supplied, and from which reflected power is returned to the plasma supply device (10, 10'), at least in the case of mismatch, **characterised in that** at least one inverter (11, 12, 11', 12') connected to a DC power supply (13, 14, 13', 14'), which inverter has at least one switching element (11.1, 11.2, 12.1, 12.2), and at least one output network (15, 15') are provided, wherein the at least one output network (15, 15') produces a sinusoidal output signal from the alternating signal generated by the inverter (11, 12, 11', 12'), and the at least one output network (15, 15') is arranged on a printed circuit board (PCB) (38).

2. The plasma supply device according to claim 1, **characterised in that** the at least one output network (15, 15') has at least one inductance (21a, 21b, 29) designed in planar technology.

3. The plasma supply device according to one of the preceding claims, **characterised in that** the printed circuit board (PCB) (38) is produced from glass fibre reinforced epoxy resin, in particular FR4 or FR5 material.

4. The plasma supply device according to one of the preceding claims, **characterised in that** the at least one output network (15, 15') has at least one output transformer (17) with a primary-side winding (18) and a secondary-side winding (19), wherein the at least one output transformer (17) is designed in planar technology.

5. The plasma supply device according to Claim 4, **characterised in that** the capacitance formed by the conductor paths forms an LC filter between the turns (31a, 31b) of the secondary-side winding (19) of the at least one output transformer (17) together with the inductance of the secondary-side winding (19) of the at least one output transformer (17).

6. The plasma supply device according to Claim 5, **characterised in that** the capacitance formed by the conductor paths between the primary-side winding (18) and the secondary-side winding (19) of the at least one output transformer (17) is a further component of the LC filter.

7. The plasma supply device according to one of Claims 5 or 6, **characterised in that** the at least one output network (15, 15') has at least one impedance adaption element (28) arranged between the secondary-side winding (19) and at least one output connection (27) for the connection of a load (16), with one or a plurality of second inductances (29) and/or one or a plurality of capacitors (30a, 30b).

8. The plasma supply device according to Claim 7, **characterised in that** the capacitor or capacitors (30a, 30b) are designed in planar technology and/or as SMD component(s).

9. The plasma supply device according to one of Claims 2 to 8, **characterised in that** at least one magnetic field strengthening element (41, 42, 55) assigned to one or a plurality of inductances (21a, 21b, 29) and/or windings (18, 19) of the at least one output transformer (17) is provided on the printed circuit board (PCB) (38).

10. The plasma supply device according to Claim 9, **characterised in that** the at least one magnetic field strengthening element (41, 42, 55) is a ferrite, in particular a perminvar ferrite.

11. The plasma supply device according to Claim 9 or 10, **characterised in that** at least one recess is formed on the printed circuit board (PCB) (38) for receiving the at least one magnetic field strengthening element (41, 42, 55).

12. The plasma supply device according to one of the preceding claims, **characterised in that** the plasma supply device (10) has a cooling plate (40) connected to the printed circuit board (PCB) (38).

13. The plasma supply device according to Claim 12, **characterised in that** the printed circuit board (PCB) (38) is arranged so that it is separated from the cooling plate (40), in particular by a distance of 5 mm to 20 mm, wherein one or a plurality of preferably electrically insulating heat transmission elements (43a, 43b, 43c, 44) and/or magnetic field strengthening elements (41, 42, 55) are arranged between the printed circuit board (PCB) (38) and the cooling plate (40).

14. The plasma supply device according to one or the preceding claims, **characterised in that** at least two output networks (15, 15') are present whose output powers are combined to one total power by means of at least one coupler (59).

15. The plasma supply device according to Claim 14, **characterised in that** the at least one coupler (59) is arranged on the circuit board (58) and is designed preferably at least partially in planar technology.

## Revendications

1. Dispositif d'alimentation en plasma (10, 10') permettant de produire une puissance de sortie supérieure à 500 W à une fréquence fondamentale sensiblement constante supérieure à 3 MHz et d'alimenter en puissance un procédé au plasma auquel la puissance de sortie ainsi produite est fournie et qui renvoie au dispositif d'alimentation en plasma (10, 10') la puissance réfléchie au moins en cas de défaut d'adaptation, **caractérisé en ce qu'**au moins un convertisseur (11, 12, 11', 12') raccordé à une alimentation en courant continu (13, 14, 13', 14'), qui présente au moins un élément de commutation (11.1, 11.2, 12.1, 12.2), et au moins un réseau de sortie (15, 15') générant un signal de sortie sinusoïdal à partir du signal alternatif généré par le convertisseur (11, 12, 11', 12') sont prévus, ledit au moins un réseau de sortie (15, 15') étant disposé sur une carte de circuit imprimé (38).

2. Dispositif d'alimentation en plasma selon la revendication 1, **caractérisé en ce que** ledit au moins un réseau de sortie (15, 15') présente au moins une inductance (21a, 21b, 29) réalisée en technologie planar.

3. Dispositif d'alimentation en plasma selon l'une des revendications précédentes, **caractérisé en ce que** la carte de circuit imprimé (38) est réalisée en résine époxyde renforcée de fibre de verre, en particulier en matériau FR4 ou FR5.

4. Dispositif d'alimentation en plasma selon l'une des revendications précédentes, **caractérisé en ce que** ledit au moins un réseau de sortie (15, 15') présente au moins un transformateur de sortie (17) avec un enroulement primaire (18) et un enroulement secondaire (19), ledit au moins un transformateur de sortie (17) étant réalisé en technologie planar.

5. Dispositif d'alimentation en plasma selon la revendication 4, **caractérisé en ce que** la capacité formée par les pistes conductrices entre les spires (31a, 31b) de l'enroulement secondaire (19) dudit au moins un transformateur de sortie (17) forme avec l'inductance de l'enroulement secondaire (19) dudit au moins un transformateur de sortie (17) un filtre LC.

6. Dispositif d'alimentation en plasma selon la revendication 5, **caractérisé en ce que** la capacité formée par les pistes conductrices entre l'enroulement primaire (18) et l'enroulement secondaire (19) dudit au moins un transformateur de sortie (17) est une composante supplémentaire du filtre LC.

7. Dispositif d'alimentation en plasma selon l'une des revendications 5 ou 6, **caractérisé en ce que** ledit au moins un réseau de sortie (15, 15') présente, disposé entre l'enroulement secondaire (19) et au moins une borne de sortie (27) pour le raccordement d'une charge (16), au moins un élément d'adaptation d'impédance (28) avec une ou plusieurs deuxièmes inductances (29) et/ou un ou plusieurs condensateurs (30a, 30b).

8. Dispositif d'alimentation en plasma selon la revendication 7, **caractérisé en ce que** le ou les condensateur(s) (30a, 30b) sont réalisés en technologie planar et/ou sous la forme de composants montés en surface.

9. Dispositif d'alimentation en plasma selon l'une des revendications 2 à 8, **caractérisé en ce qu'**au moins un élément amplificateur de champ magnétique (41, 42, 55) associé à une ou plusieurs inductances (21a, 21b, 29) et/ou enroulements (18, 19) dudit au moins un transformateur de sortie (17) est prévu sur la carte de circuit imprimé (38).

10. Dispositif d'alimentation en plasma selon la revendication 9, **caractérisé en ce que** ledit au moins un élément amplificateur de champ magnétique (41, 42, 55) est une ferrite, en particulier une ferrite en perminvar.

11. Dispositif d'alimentation en plasma selon la revendication 9 ou 10, **caractérisé en ce qu'**au moins un évidement destiné à recevoir ledit au moins un élément amplificateur de champ magnétique (41, 42, 55) est formé sur la carte de circuit imprimé (38).

12. Dispositif d'alimentation en plasma selon l'une des revendications précédentes, **caractérisé en ce que** le dispositif d'alimentation en plasma (10) présente une plaque de refroidissement (40) reliée à la carte de circuit imprimé (38).

13. Dispositif d'alimentation en plasma selon la revendication 12, **caractérisé en ce que** la carte de circuit imprimé (38) est espacée de la plaque de refroidissement (40), en particulier disposée à une distance de 5 mm à 20 mm, un ou plusieurs éléments de transfert de chaleur (43a, 43b, 43c, 44), de préférence électriquement isolants, et/ou éléments amplificateurs de champ magnétique (41, 42, 55) étant disposés entre la carte de circuit imprimé (38) et la plaque de refroidissement (40).

14. Dispositif d'alimentation en plasma selon l'une des revendications précédentes, **caractérisé en ce qu'**au moins deux réseaux de sortie (15, 15') sont présents, dont les puissances de sortie sont réunies en une puissance totale par au moins un coupleur (59).

15. Dispositif d'alimentation en plasma selon la revendication 14, **caractérisé en ce que** ledit au moins un coupleur (59) est disposé sur la carte de circuit imprimé (58) et de préférence réalisé au moins en partie en technologie planar.
